# EUROPEAN PATENT APPLICATION

(11) **EP 4 053 091 A1**
(43) Date of publication of application: **07.09.2022**
(21) Application number: 20883449.9
(22) Date of filing: 28.10.2020
(51) Int. Cl.: C04B 37/02, H01L 23/12, H01L 23/13, H05K 3/38

(54) **COPPER/CERAMIC ASSEMBLY, INSULATED CIRCUIT BOARD, METHOD FOR PRODUCING COPPER/CERAMIC ASSEMBLY, AND METHOD FOR PRODUCING INSULATED CIRCUIT BOARD**

(30) Priority: 30.10.2019 JP 2019197656; 26.10.2020 JP 2020179054
(71) Applicant: Mitsubishi Materials Corporation, Tokyo 100-8117 (JP)
(72) Inventor: TERASAKI Nobuyuki, Saitama-shi, Saitama 330-8508 (JP)
(74) Representative: Hoffmann Eitle
(86) International application number: PCT/JP2020/040363
(87) International publication number: WO 2021/085451

(57) **Abstract**

A copper/ceramic bonded body includes: a copper member (12) made of copper or a copper alloy; and a ceramic member (11) made of nitrogen-containing ceramics, the copper member (12) and the ceramic member (11) being bonded to each other, in which a Mg solid solution layer in which Mg is solid-soluted in a Cu matrix is formed at a bonding interface between the copper member (12) and the ceramic member (11), an active metal nitride layer (41) containing a nitride of one or more active metals selected from Ti, Zr, Nb, and Hf is formed on a ceramic member (11) side, and a thickness of the active metal nitride layer (41) is set to be in a range of 0.05 µm or more and 1.2 µm or less.

## Description

### [Technical Field]

The present invention relates to a copper/ceramic bonded body in which a copper member made of copper or a copper alloy and a ceramic member are bonded to each other, an insulating circuit substrate in which a copper plate made of copper or a copper alloy is bonded to a surface of a ceramic substrate, a production method of a copper/ceramic bonded body, and a production method of an insulating circuit substrate.

Priority is claimed on Japanese Patent Application No. 2019-197656, filed October 30, 2019, and Japanese Patent Application No. 2020-179054, filed October 26, 2020, the contents of which are incorporated herein by reference.

### [Background Art]

A power module, an LED module, and a thermoelectric module have a structure in which a power semiconductor element, an LED element, and a thermoelectric element are bonded to an insulating circuit substrate in which a circuit layer made of a conductive material is formed on one surface of an insulating layer.

For example, a power semiconductor element for high-power control used for controlling a wind power generation, an electric vehicle, a hybrid vehicle, or the like has a large amount of heat generated during operation. Therefore, as a substrate on which the power semiconductor element is mounted, an insulating circuit substrate including a ceramic substrate and a circuit layer formed by bonding a metal plate having excellent conductivity to one surface of the ceramic substrate has been widely used in the related art. As the insulating circuit substrate, one having a metal layer formed by bonding a metal plate to the other surface of the ceramic substrate is also provided.

For example, Patent Document 1 proposes an insulating circuit substrate in which a circuit layer and a metal layer are formed by bonding a copper plate to one surface and the other surface of a ceramic substrate. In Patent Document 1, the copper plate is disposed on one surface and the other surface of the ceramic substrate with an Ag-Cu-Ti-based brazing material interposed therebetween, and the copper plate is bonded thereto by performing a heating treatment (so-called active metal brazing method). In the active metal brazing method, since the brazing material containing Ti as an active metal is used, the wettability between the molten brazing material and the ceramic substrate is improved, and the ceramic substrate and the copper plate are satisfactorily bonded to each other.

Patent Document 2 proposes an insulating circuit substrate in which a ceramic substrate and a copper plate are bonded to each other by using a Cu-Mg-Ti-based brazing material.

In Patent Document 2, the bonding is performed by heating at 560°C to 800°C in a nitrogen gas atmosphere, and Mg in a Cu-Mg-Ti alloy is sublimated and does not remain at a bonding interface, while titanium nitride (TiN) is not substantially formed.

### [Citation List]

### [Patent Documents]

[Patent Document 1] Japanese Patent No. 3211856 (B)
[Patent Document 2] Japanese Patent No. 4375730 (B)

### [Summary of Invention]

### [Technical Problem]

By the way, in a high-temperature semiconductor device using SiC or the like, it may be mounted at a high density, and it is necessary to ensure operation at a higher temperature in the insulating circuit substrate.

Therefore, it is necessary to suppress occurrence of breaking in the ceramic substrate even when a thermal cycle that is more severe than in the related art is loaded.

As disclosed in Patent Document 1, when the ceramic substrate and the copper plate are bonded to each other by the active metal brazing method, since Ag is present at a bonding interface, migration is likely to occur when used under a high-temperature and high-humidity condition, and use for high voltage applications cannot be achieved.

The present invention has been made in view of the above-described circumstances, and an objective of the present invention is to provide a copper/ceramic bonded body, an insulating circuit substrate, a production method of a copper/ceramic bonded body, and a production method of an insulating circuit substrate, which can suppress occurrence of breaking in a ceramic member even when severe thermal cycle is loaded, and are excellent in migration resistance.

### [Solution to Problem]

In order to solve the above-described problem, a copper/ceramic bonded body according to one aspect of the present invention (hereinafter, referred to as a "copper/ceramic bonded body") includes a copper member made of copper or a copper alloy, and a ceramic member made of nitrogen-containing ceramics, the copper member and the ceramic member being bonded to each other, in which a Mg solid solution layer in which Mg is solid-soluted in a Cu matrix is formed at a bonding interface between the copper member and the ceramic member, an active metal nitride layer containing a nitride of one or more active metals selected from Ti, Zr, Nb, and Hf is formed on a ceramic member side, and a thickness of the active metal nitride layer is set to be in a range of 0.05 µm or more and 1.2 µm or less.

According to the copper/ceramic bonded body of the present invention, the active metal nitride layer containing a nitride of one or more active metals selected from Ti, Zr, Nb, and Hf is formed on the ceramic member side of the bonding interface between the copper member and the ceramic member, and the thickness of the active metal nitride layer is set to 0.05 µm or more. Therefore, uniform interfacial reaction proceeds during bonding, and occurrence of breaking in the ceramic member during loading of the thermal cycle can be suppressed. In addition, since the thickness of the active metal nitride layer is 1.2 µm or less, it is possible to suppress occurrence of breaking in the ceramic member during loading of the thermal cycle.

In addition, since Ag is not present at the bonding interface, excellent migration resistance is obtained.

Here, in the copper/ceramic bonded body according to the present invention, it is preferable that the active metal is Ti.

In this case, Ti sufficiently reacts with a bonding surface of the ceramic member to form an active metal nitride layer made of titanium nitride, whereby the ceramic member and the copper member can be reliably bonded to each other.

In addition, in the copper/ceramic bonded body according to the present invention, it is preferable that Cu-containing particles are present inside the active metal nitride layer.

In this case, the strength of the active metal nitride layer formed at the bonding interface is improved, and peeling of the ceramic member from the copper member can be suppressed, for example, when ultrasonic waves are applied to ultrasonically bond a terminal material or the like to the copper member.

An insulating circuit substrate according to another aspect of the present invention (hereinafter, referred to as an "insulating circuit substrate according to the present invention") includes a copper plate made of copper or a copper alloy, and a ceramic substrate made of nitrogen-containing ceramics, the copper plate being bonded to a surface of the ceramic substrate, in which a Mg solid solution layer in which Mg is solid-soluted in a Cu matrix is formed at a bonding interface between the copper plate and the ceramic substrate, an active metal nitride layer containing a nitride of one or more active metals selected from Ti, Zr, Nb, and Hf is formed on a ceramic substrate side, and a thickness of the active metal nitride layer is set to be in a range of 0.05 µm or more and 1.2 µm or less.

According to the insulating circuit substrate of the present invention, the active metal nitride layer containing a nitride of one or more active metals selected from Ti, Zr, Nb, and Hf is formed on the ceramic substrate side of the bonding interface between the copper plate and the ceramic substrate, and the thickness of the active metal nitride layer is set to 0.05 µm or more. Therefore, uniform interfacial reaction proceeds during bonding, and occurrence of breaking in the ceramic member during loading of the thermal cycle can be suppressed. In addition, since the thickness of the active metal nitride layer is 1.2 µm or less, it is possible to suppress occurrence of breaking in the ceramic substrate during loading of the thermal cycle.

In addition, since Ag is not present at the bonding interface, excellent migration resistance is obtained.

Here, in the insulating circuit substrate according to the present invention, it is preferable that the active metal is Ti.

In this case, Ti sufficiently reacts with a bonding surface of the ceramic substrate to form an active metal nitride layer made of titanium nitride, whereby the ceramic substrate and the copper plate can be reliably bonded to each other.

In addition, in the insulating circuit substrate according to the present invention, it is preferable that Cu-containing particles are present inside the active metal nitride layer.

In this case, the strength of the active metal nitride layer formed at the bonding interface is improved, and peeling of the ceramic substrate from the copper plate can be suppressed, for example, when ultrasonic waves are applied to ultrasonically bond a terminal material or the like to the insulating circuit substrate.

A production method of a copper/ceramic bonded body according to still another aspect of the present invention (hereinafter, referred to as a "production method of a copper/ceramic bonded body according to the present invention") is a method of producing the copper/ceramic bonded body described above, the production method including an active metal and Mg disposing step of disposing one or more active metals selected from Ti, Zr, Nb, and Hf and Mg between the copper member and the ceramic member, a laminating step of laminating the copper member and the ceramic member with the active metal and Mg interposed therebetween, and a bonding step of performing a heating treatment on the laminated copper member and ceramic member with the active metal and Mg interposed therebetween in a state of being pressed in a lamination direction under a vacuum atmosphere to bond the copper member and the ceramic member to each other, in which, in the active metal and Mg disposing step, an amount of the active metal is set to be in a range of 0.4 µmol/cm² or more and 18.8 µmol/cm² or less, and an amount of Mg is set to be in a range of 14 µmol/cm² or more and 86 µmol/cm² or less, and in the bonding step, a temperature increase rate in a temperature range of 450°C or higher and lower than 650°C is set to 5 °C/min or higher and 20 °C/min or lower, a holding temperature is set to be in a range of 700°C or higher and 850°C or lower, and a holding time at the holding temperature is set to be in a range of 10 minutes or longer and 180 minutes or shorter.

According to the production method of a copper/ceramic bonded body having the configuration, the amount of the active metal is set to be in the range of 0.4 µmol/cm² or more and 18.8 µmol/cm² or less, and the amount of Mg is set to be in the range of 14 µmol/cm² or more and 86 µmol/cm² or less. Therefore, a sufficient liquid phase required for an interfacial reaction can be obtained. Accordingly, the copper member and the ceramic member can be reliably bonded to each other.

In addition, in a state where Mg and the active metal are interposed as described above, in the bonding step, the temperature increase rate in the temperature range of 450°C or higher and lower than 650°C is set to 5 °C/min or higher and 20 °C/min or lower, and the holding temperature is set to be in the range of 700°C or higher and 850°C or lower, and the holding time at the holding temperature is set to be in the range of 10 minutes or longer and 180 minutes or shorter. Therefore, the active metal nitride layer is formed at the bonding interface, and it is suppressed that the active metal nitride layer grows thicker than necessary. Thereby, the thickness of the active metal nitride layer can be set in a range of 0.05 µm or more and 1.2 µm or less.

A production method of an insulating circuit substrate according to still another aspect of the present invention (hereinafter, referred to as a "production method of an insulating circuit substrate according to the present invention") is a method of producing the insulating circuit substrate described above, the production method including an active metal and Mg disposing step of disposing one or more active metals selected from Ti, Zr, Nb, and Hf and Mg between the copper plate and the ceramic substrate, a laminating step of laminating the copper plate and the ceramic substrate with the active metal and Mg interposed therebetween, and a bonding step of performing a heating treatment on the laminated copper plate and ceramic substrate with the active metal and Mg interposed therebetween in a state of being pressed in a lamination direction under a vacuum atmosphere to bond the copper plate and the ceramic substrate to each other, in which, in the active metal and Mg disposing step, an amount of the active metal is set to be in a range of 0.4 µmol/cm² or more and 18.8 µmol/cm² or less, and an amount of Mg is set to be in a range of 14 µmol/cm² or more and 86 µmol/cm² or less, and in the bonding step, a temperature increase rate in a temperature range of 450°C or higher and lower than 650°C is set to 5 °C/min or higher and 20 °C/min or lower, a holding temperature is set to be in a range of 700°C or higher and 850°C or lower, and a holding time at the holding temperature is set to be in a range of 10 minutes or longer and 180 minutes or shorter.

According to the production method of an insulating circuit substrate having the configuration, the amount of the active metal is set to be in the range of 0.4 µmol/cm² or more and 18.8 µmol/cm² or less, and the amount of Mg is set to be in the range of 14 µmol/cm² or more and 86 µmol/cm² or less. Therefore, a sufficient liquid phase required for an interfacial reaction can be obtained. Accordingly, the copper plate and the ceramic substrate can be reliably bonded to each other.

In addition, in a state where Mg and the active metal are interposed as described above, in the bonding step, the temperature increase rate in the temperature range of 450°C or higher and lower than 650°C is set to 5 °C/min or higher and 20 °C/min or lower, and the holding temperature is set to be in the range of 700°C or higher and 850°C or lower, and the holding time at the holding temperature is set to be in the range of 10 minutes or longer and 180 minutes or shorter. Therefore, the active metal nitride layer is formed at the bonding interface, and it is suppressed that the active metal nitride layer grows thicker than necessary. Thereby, the thickness of the active metal nitride layer can be set in a range of 0.05 µm or more and 1.2 µm or less.

### [Advantageous Effects of Invention]

According to the present invention, it is possible to provide a copper/ceramic bonded body, an insulating circuit substrate, a production method of a copper/ceramic bonded body, and a production method of an insulating circuit substrate, which can suppress occurrence of breaking of a ceramic member even when severe thermal cycle is loaded, and are excellent in migration resistance.

### [Brief Description of Drawings]

Fig. 1 is a schematic explanatory view of a power module using an insulating circuit substrate according to an embodiment of the present invention.
Fig. 2 is an enlarged explanatory view of a bonding interface between a circuit layer (metal layer) and a ceramic substrate of the insulating circuit substrate according to the embodiment of the present invention.
Fig. 3 is a flowchart of a method of producing the insulating circuit substrate according to the embodiment of the present invention.
Fig. 4 is a schematic explanatory view of the method of producing the insulating circuit substrate according to the embodiment of the present invention.

### [Description of Embodiments]

Hereinafter, an embodiment of the present invention will be described with reference to the accompanying drawings.

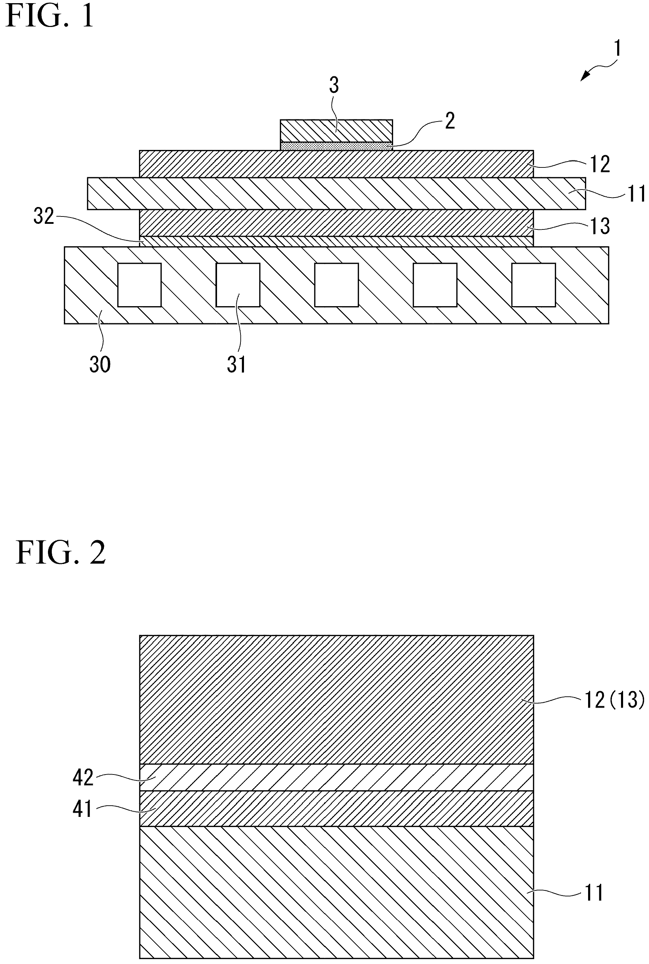

A bonded body according to the present embodiment is an insulating circuit substrate 10 formed by bonding a ceramic substrate 11 as a ceramic member made of ceramics to a copper plate 22 (circuit layer 12) and a copper plate 23 (metal layer 13) as a copper member made of copper or a copper alloy. Fig. 1 shows a power module 1 including an insulating circuit substrate 10 according to the present embodiment.

The power module 1 includes the insulating circuit substrate 10 on which the circuit layer 12 and the metal layer 13 are disposed, a semiconductor element 3 bonded to one surface (upper surface in Fig. 1) of the circuit layer 12 with a bonding layer 2 interposed therebetween, and a heat sink 30 disposed on the other side (lower side in Fig. 1) of the metal layer 13.

The semiconductor element 3 is made of a semiconductor material such as Si. The semiconductor element 3 and the circuit layer 12 are bonded to each other with the bonding layer 2 interposed therebetween.

The bonding layer 2 is made of, for example, a Sn-Ag-based, Sn-In-based, or Sn-Ag-Cu-based solder material.

The heat sink 30 dissipates heat from the insulating circuit substrate 10 described above. The heat sink 30 is made of copper or a copper alloy, and in the present embodiment, the heat sink 30 is made of phosphorus deoxidized copper. The heat sink 30 is provided with a passage 31 through which a cooling fluid flows.

In the present embodiment, the heat sink 30 and the metal layer 13 are bonded to each other by a solder layer 32 made of a solder material. The solder layer 32 is made of, for example, a Sn-Ag-based, Sn-In-based, or Sn-Ag-Cu-based solder material.

As shown in Fig. 1, the insulating circuit substrate 10 of the present embodiment includes the ceramic substrate 11, the circuit layer 12 disposed on one surface (upper surface in Fig. 1) of the ceramic substrate 11, and the metal layer 13 disposed on the other surface (lower surface in Fig. 1) of the ceramic substrate 11.

The ceramic substrate 11 is made of nitrogen-containing ceramics having excellent insulating properties and heat radiation, and in the present embodiment, the ceramic substrate 11 is made of aluminum nitride (AlN). The thickness of the ceramic substrate 11 is set to be in a range of, for example, 0.2 mm or more and 1.5 mm or less, and in the present embodiment, the thickness is set to 0.635 mm. In addition to aluminum nitride (AlN), silicon nitride (Si₃N₄) can be used.

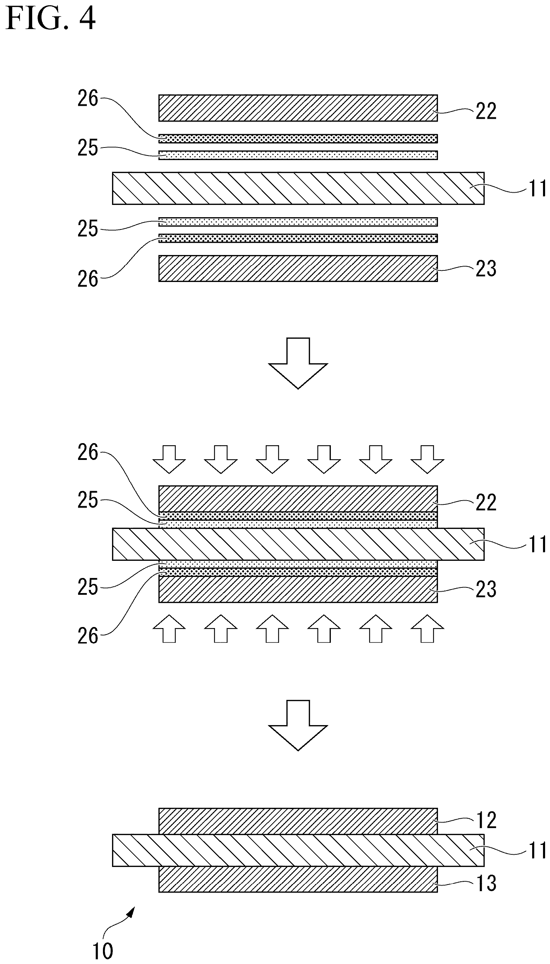

As shown in Fig. 4, the circuit layer 12 is formed by bonding the copper plate 22 made of copper or a copper alloy to one surface (upper surface in Fig. 4) of the ceramic substrate 11.

In the present embodiment, the circuit layer 12 is formed by bonding the copper plate 22 made of a rolled plate of oxygen-free copper to the ceramic substrate 11.

The thickness of the copper plate 22 serving as the circuit layer 12 is set to be in a range of 0.1 mm or more and 2.0 mm or less, and in the present embodiment, the thickness is set to 0.6 mm.

As shown in Fig. 4, the metal layer 13 is formed by bonding the copper plate 23 made of copper or a copper alloy to the other surface (lower surface in Fig. 4) of the ceramic substrate 11.

In the present embodiment, the metal layer 13 is formed by bonding the copper plate 23 made of a rolled plate of oxygen-free copper to the ceramic substrate 11.

The thickness of the copper plate 23 serving as the metal layer 13 is set to be in a range of 0.1 mm or more and 2.0 mm or less, and in the present embodiment, the thickness is set to 0.6 mm.

At the bonding interface between the ceramic substrate 11 and the circuit layer 12 (metal layer 13), as shown in Fig. 2, an active metal nitride layer 41 containing a nitride of one or more active metals selected from Ti, Zr, Nb, and Hf is formed on the ceramic substrate 11 side.

The thickness of the active metal nitride layer 41 is set to be in a range of 0.05 µm or more and 1.2 µm or less. In the present embodiment, it is preferable to use Ti as the active metal.

The thickness of the active metal nitride layer 41 may be set to be in a range of 0.15 µm or more and 1.0 µm or less, or may be set to be in a range of 0.16 µm or more and 0.89 µm or less.

In addition, as shown in Fig. 2, on the circuit layer 12 (metal layer 13) side of the active metal nitride layer 41, a Mg solid solution layer 42 in which Mg is solid-soluted in Cu is formed.

Further, in the present embodiment, it is preferable that one or more Cu-containing particles selected from Cu particles, compound particles of Cu and active metals, and compound particles of Cu and Mg are present inside the active metal nitride layer 41. The Cu-containing particles may be dispersed inside the active metal nitride layer 41.

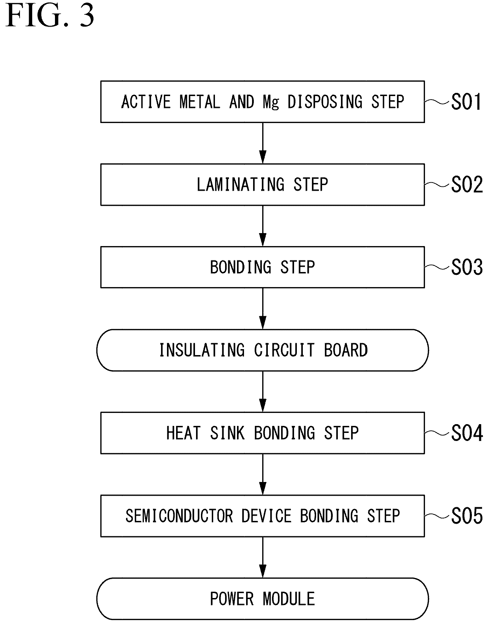

Hereinafter, a method of producing the insulating circuit substrate 10 according to the present embodiment will be described with reference to Figs. 3 and 4.

### (Active Metal and Mg Disposing Step S01)

First, the ceramic substrate 11 made of aluminum nitride (AlN) is prepared, and as shown in Fig. 4, one or more active metals selected from Ti, Zr, Nb, and Hf and Mg are disposed between the copper plate 22 serving as the circuit layer 12 and the ceramic substrate 11, and between the copper plate 23 serving as the metal layer 13 and the ceramic substrate 11.

In the present embodiment, a Mg foil 25 and an active metal foil 26 are disposed between the copper plate 22 serving as the circuit layer 12 and the ceramic substrate 11, and between the copper plate 23 serving as the metal layer 13 and the ceramic substrate 11.

Here, in an active metal and Mg disposing step S01, the amount of the active metal to be disposed is set to be in a range of 0.4 µmol/cm² or more and 18.8 µmol/cm² or less, and an amount of Mg is set to be in a range of 14 µmol/cm² or more and 86 µmol/cm² or less.

The lower limit of the amount of the active metal to be disposed is preferably 0.9 µmol/cm² or more, and more preferably 2.8 µmol/cm² or more. On the other hand, the upper limit of the amount of the active metal to be disposed is preferably 9.4 µmol/cm² or less, and more preferably 6.6 µmol/cm² or less.

In addition, the lower limit of the amount of Mg to be disposed is preferably 21 µmol/cm² or more, and more preferably 28 µmol/cm² or more. On the other hand, the upper limit of the amount of the Mg to be disposed is preferably 72 µmol/cm² or less, and more preferably 57 µmol/cm² or less.

### (Laminating Step S02)

Next, the copper plate 22 and the ceramic substrate 11 are laminated with the active metal foil 26 and the Mg foil 25 interposed therebetween, and the ceramic substrate 11 and the copper plate 23 are laminated with the active metal foil 26 and the Mg foil 25 interposed therebetween.

### (Bonding Step S03)

Next, the copper plate 22, the active metal foil 26, the Mg foil 25, the ceramic substrate 11, the Mg foil 25, the active metal foil 26, and the copper plate 23 which are laminated are pressed in a lamination direction, and are loaded into a vacuum furnace and heated such that the copper plate 22, the ceramic substrate 11, and the copper plate 23 are bonded together.

Here, heating treatment conditions in a bonding step S03 are such that a temperature increase rate in a temperature range of 450°C or higher and lower than 650°C is set to 5 °C/min or higher and 20 °C/min or lower, a holding temperature is set to be in a range of 700°C or higher and 850°C or lower, and a holding time at the holding temperature is set to be in a range of 10 minutes or longer and 180 minutes or shorter.

The lower limit of the temperature increase rate in the temperature range of 450°C or higher and lower than 650°C is preferably 7 °C/min or higher, and more preferably 9 °C/min or higher. On the other hand, the upper limit of the temperature increase rate in the temperature range of 450°C or higher and lower than 650°C is preferably 15 °C/min or lower, and more preferably 20 °C/min or lower.

In addition, the lower limit of the holding temperature is preferably 730°C or higher, and more preferably 760°C or higher. In addition, the upper limit of the holding temperature is preferably 850°C or lower, and more preferably 830°C or lower.

Further, the lower limit of the holding time is preferably 30 minutes or longer, and more preferably 45 minutes or longer. On the other hand, the upper limit of the holding time is preferably 150 minutes or shorter, and more preferably 120 minutes or shorter.

A pressing load in the bonding step S03 is preferably in a range of 0.049 MPa or more and 3.4 MPa or less.

Further, a degree of vacuum in the bonding step S03 is preferably in a range of 1 × 10⁻⁶ Pa or more and 5 × 10⁻² Pa or less.

As described above, by the active metal and Mg disposing step S01, the laminating step S02, and the bonding step S03, the thickness of the active metal nitride layer 41 formed at the bonding interface between the circuit layer 12 (metal layer 13) and the ceramic substrate 11 is in a range of 0.05 µm or more and 1.2 µm or less, and the insulating circuit substrate 10 of the present embodiment is produced.

### (Heat Sink Bonding Step S04)

Next, the heat sink 30 is bonded to the other surface side of the metal layer 13 of the insulating circuit substrate 10.

The insulating circuit substrate 10 and the heat sink 30 are laminated with a solder material interposed therebetween and are loaded into a heating furnace such that the insulating circuit substrate 10 and the heat sink 30 are solder-bonded to each other with the solder layer 32 interposed therebetween.

### (Semiconductor Element-Bonding Step S05)

Next, the semiconductor element 3 is bonded to one surface of the circuit layer 12 of the insulating circuit substrate 10 by soldering.

The power module 1 shown in Fig. 1 is produced by the above steps.

According to the insulating circuit substrate 10 (copper/ceramic bonded body) of the present embodiment having the above configuration, the active metal nitride layer 41 containing a nitride of one or more active metals selected from Ti, Zr, Nb, and Hf is formed on the ceramic substrate 11 side of the bonding interface between the circuit layer 12 and the metal layer 13 and the ceramic substrate 11, and the thickness of the active metal nitride layer 41 is set to 0.05 µm or more. Therefore, uniform interfacial reaction proceeds during bonding, and occurrence of breaking in the ceramic substrate 11 during loading of the thermal cycle can be suppressed. That is, when the thickness of the active metal nitride layer 41 is less than 0.05 µm, the interfacial reaction may be insufficient, and there is a possibility that a region where the active metal nitride layer 41 is partially absent is present, and such a region may become a starting point of local breakage of the ceramic substrate 11. As a result, breaking in the ceramic substrate 11 occurs during loading of the thermal cycle. In addition, since the thickness of the active metal nitride layer 41 is 1.2 µm or less, it is possible to suppress occurrence of breaking in the ceramic substrate 11 during loading of the thermal cycle.

Further, since Ag is not present at the bonding interface, excellent migration resistance is obtained, and pressure resistance can be secured even when used under a high-temperature and high-humidity condition.

In the present embodiment, when the active metal is Ti, Ti sufficiently reacts with the ceramic substrate 11 to form the active metal nitride layer 41 made of titanium nitride, and the ceramic substrate 11 and the circuit layer 12 (and the metal layer 13) can be reliably bonded to each other.

Further, in the present embodiment, in a case where one or more Cu-containing particles selected from Cu particles, compound particles of Cu and active metals, and compound particles of Cu and Mg are present inside the active metal nitride layer 41, the strength of the active metal nitride layer 41 formed at the bonding interface is improved. Therefore, even when ultrasonic waves are applied to the insulating circuit substrate 10 (copper/ceramic bonded body) for ultrasonic bonding of the terminal material or the like to the circuit layer 12 (metal layer 13), peeling of the ceramic substrate 11 from the circuit layer 12 (metal layer 13) can be suppressed.

According to the method of producing the insulating circuit substrate according to the present embodiment, since the amount of the active metal is set to be in a range of 0.4 µmol/cm² or more and 18.8 µmol/cm² or less, and the amount of Mg is set to be in a range of 14 µmol/cm² or more and 86 µmol/cm² or less, a sufficient liquid phase required for an interfacial reaction can be obtained. Therefore, the circuit layer 12 and the metal layer 13 can be reliably bonded to the ceramic substrate 11. When the amount of the active metal exceeds 18.8 µmol/cm², the interfacial reaction becomes excessive, and the active metal nitride layer grows excessively and becomes thick. When the amount of the active metal is less than 0.4 µmol/cm², the interfacial reaction becomes small and the active metal nitride layer cannot grow sufficiently, so that the active metal nitride layer becomes thin. When the amount of Mg exceeds 86 µmol/cm², the amount of the liquid phase becomes excessive, and the active metal nitride layer grows excessively and becomes thick. When the amount of Mg is less than 14 µmol/cm², the amount of the liquid phase is insufficient, the active metal nitride layer cannot grow sufficiently and becomes thin.

In a state where Mg and the active metal are interposed as described above, in the bonding step S03, the temperature increase rate in the temperature range of 450°C or higher and lower than 650°C is set to 5 °C/min or higher and 20 °C/min or lower, and the holding temperature is set to be in the range of 700°C or higher and 850°C or lower, and the holding time at the holding temperature is set to be in the range of 10 minutes or longer and 180 minutes or shorter. Therefore, the active metal nitride layer 41 can be formed at the bonding interface, and it can be suppressed that the active metal nitride layer 41 grows thicker than necessary. Thereby, the thickness of the active metal nitride layer 41 can be set in a range of 0.05 µm or more and 1.2 µm or less. When the temperature increase rate exceeds 20 °C/min, the amount of Mg consumed due to the diffusion of Mg into Cu and the growth of the Cu-Mg intermetallic compound phase is small, the amount of the liquid phase generated becomes excessive, and the active metal nitride layer grows excessively and becomes thick. When the temperature increase rate is less than 5 °C/min, the amount of Mg consumed increases due to the diffusion of Mg into Cu and the growth of the Cu-Mg intermetallic compound phase, and the amount of the liquid phase generated is insufficient, so that the active metal nitride layer cannot grow sufficiently and becomes thin.

Since the holding temperature is 850°C or lower, the excessive growth of the active metal nitride layer can be suppressed by not exceeding the eutectic temperature of Cu and the active metal, and since the holding temperature is 700°C or higher, the interfacial reaction can reliably proceed by exceeding the melting point of Mg. Since the holding time is 180 minutes or shorter, the interfacial reaction does not proceed excessively, while since the holding time is 10 minutes or longer, the interfacial reaction can reliably proceed.

The embodiment of the present invention has been described, but the present invention is not limited thereto, and can be appropriately changed without departing from the technical ideas of the present invention.

For example, in the present embodiment, the semiconductor element is mounted on the insulating circuit substrate to form the power module, but the present embodiment is not limited thereto. For example, an LED element may be mounted on the circuit layer of the insulating circuit substrate to form an LED module, or a thermoelectric element may be mounted on the circuit layer of the insulating circuit substrate to form a thermoelectric module.

In the insulating circuit substrate of the present embodiment, it has been described that the circuit layer and the metal layer are both made of a copper plate made of copper or a copper alloy, but the present invention is not limited thereto.

For example, in a case where the circuit layer and the ceramic substrate are made of the copper/ceramic bonded body according to the present invention, there is no limitation on the material and the bonding method of the metal layer. There may be no metal layer, the metal layer may be made of aluminum or an aluminum alloy, or may be made of a laminate of copper and aluminum.

On the other hand, in a case where the metal layer and the ceramic substrate are made of the copper/ceramic bonded body according to the present invention, there is no limitation on the material and the bonding method of the circuit layer. The circuit layer may be made of aluminum or an aluminum alloy, or may be made of a laminate of copper and aluminum.

Further, in the present embodiment, the configuration has been described in which the active metal foil and the Mg foil are laminated between the copper plate and the ceramic substrate, but the present invention is not limited thereto, and an alloy foil of Mg and the active metal may be disposed. In addition, a thin film made of Mg, the active metal, an alloy of Mg and the active metal, or the like may be formed on the bonding surface between the ceramic substrate and the copper plate by a sputtering method, a vapor deposition method, or the like. A paste using Mg or MgH₂, a paste using an active metal or an active metal hydride, or a mixed paste thereof may also be used.

### [Examples]

Hereinafter, results of confirmation experiments performed to confirm the effects of the present invention will be described.

### (Example 1)

First, a ceramic substrate (40 mm × 40 mm × 0.635 mm) made of aluminum nitride (AlN) and a ceramic substrate (40 mm × 40 mm × 0.32 mm) made of silicon nitride (Si₃N₄) were prepared.

A copper plate (37 mm × 37 mm × thickness of 0.3 mm) made of oxygen-free copper was bonded to both surfaces of the ceramic substrate under the conditions shown in Tables 1 and 2 to obtain an insulating circuit substrate (copper/ceramic bonded body). A degree of vacuum of a vacuum furnace at the time of bonding was set to 8 × 10⁻³ Pa.

Here, in Examples 1 to 9 of Present Invention, Comparative Examples 1 to 6, and Conventional Example 1, a ceramic substrate made of aluminum nitride (AlN) was used. In addition, in Examples 11 to 19 of Present Invention, Comparative Examples 11 to 16, and Conventional Example 11, a ceramic substrate made of silicon nitride (Si₃N₄) was used. In Conventional Example 1 and Conventional Example 11, Mg was not used, but Ag was used instead, and the amount thereof was as shown in Tables 1 and 2.

For the obtained insulating circuit substrate (copper/ceramic bonded body), the thickness of the active metal nitride layer at the bonding interface, the presence or absence of the Mg solid solution layer, migration resistance, and reliability of the thermal cycle were evaluated as follows.

### (Thickness of Active Metal Nitride Layer)

An observation specimen was collected from the central portion of the cross section of the obtained insulating circuit substrate (copper/ceramic bonded body), the bonding interface between the copper plate and the ceramic substrate was observed under the conditions of a magnification of 40,000 to 115,000 and an acceleration voltage of 200 kV by using a scanning transmission electron microscope (Titan ChemiSTEM (with EDS detector) manufactured by FEI Company), mapping was performed using an energy dispersive X-ray analysis method (NSS7 manufactured by Thermo Fisher Scientific K.K.), to obtain an electron diffraction pattern by irradiating a region where the active metal and N overlap each other with an electron beam narrowed to about 1 nm (nano beam diffraction (NBD) method), and the active metal nitride layer was confirmed.

In a method for measuring the thickness of the active metal nitride layer, using the same specimen as the above observation specimen, elemental mapping of a nitride-forming element (Ti, Nb, Hf, and Zr) and N was acquired using a scanning transmission electron microscope (Titan ChemiSTEM (with EDS detector) manufactured by FEI Company), a region where the nitride-forming element and nitrogen (N) coexisted was regarded as an active metal nitride layer, an area of this region was measured, and a value obtained by dividing the area by the dimension of the width of the measurement field (for example, 16 µm in length and width in a case of a magnification of 4,000, and 0.55 µm in length and width in a case of a magnification of 115,000) was obtained. This measurement was performed on the same specimen at five points, and the arithmetic average value of the obtained values was taken as the thickness of the active metal nitride layer.

The thickness of the region formed as the active metal nitride layer was measured at five points per field of view, and the average value was taken as the thickness of the active metal nitride layer.

### (Mg Solid Solution Layer)

An observation specimen was collected from the central portion of the obtained insulating circuit substrate (copper/ceramic bonded body), a region (400 µm × 600 µm) including the bonding interface between the copper plate and the ceramic substrate was observed under the conditions of a magnification of 2,000 and an acceleration voltage of 15 kV by using an EPMA device (JXA-8539F manufactured by JEOL Ltd.), quantitative analysis was performed at 10 points at 10 µm intervals from the surface of the ceramic substrate to the copper plate side, and a region having a Mg concentration of 0.01 atomic% or more was taken as a Mg solid solution layer.

### (Migration Resistant)

Under the conditions of a distance between circuit patterns of the circuit layer of 0.8 mm, a temperature of 60°C, a humidity of 95 %RH, and a voltage of DC 50 V, the electrical resistance between the circuit patterns was measured after leaving for 500 hours, and when the resistance value was 1 × 10⁶ Ω or less, it was determined that a short-circuit occurred, and it was evaluated as "C". Others were evaluated as "A".

### (Reliability of Thermal Cycle)

After passing the furnace through the atmosphere of a thermal cycle of -78°C × 2 minutes ← → 350°C × 2 minutes, the bonding interface between the copper plate and the ceramic substrate was inspected by SAT inspection, and then the number of cycles in which ceramic breaking was confirmed was evaluated.

In Examples 1 to 9 of Present Invention and Comparative Examples 1 and 2 in which aluminum nitride (AlN) was used as the ceramic substrate, the above-described thermal cycle was performed up to 10 cycles, and a case where no breaking was confirmed after 10 cycles was indicated as "> 10".

In addition, in Examples of Present Invention 11 to 19 and Comparative Examples 11 and 12 in which silicon nitride (Si₃N₄) was used as the ceramic substrate, the above-described thermal cycle was performed up to 20 cycles, and a case where no breaking was confirmed after 20 cycles was indicated as "> 20".

**[Table 1]**

| | Mg and active metal disposing step | | | Bonding step | | | | Mg solid solution layer | Thickness of active metal nitride layer (µm) | Migration resistance | Reliability of thermal cycle |
|---|---|---|---|---|---|---|---|---|---|---|---|
| | Amount of Mg (µmol/cm²) | Active metal | | Load (MPa) | Temperature increase rate (°C/min) | Holding temperature (°C) | Holding time (min) | | | | |
| | | Element | µmol/cm², | | | | | | | | |
| Example 1 of Present Invention | 21.5 | Ti | 1.2 | 0.294 | 5 | 700 | 10 | Present | 0.05 | A | 7 |
| Example 2 of Present Invention | 42.9 | Ti | 18.8 | 0.49 | 20 | 850 | 180 | Present | 1.18 | A | 8 |
| Example 3 of Present Invention | 14.3 | Zr | 4.8 | 0.049 | 10 | 750 | 15 | Present | 0.16 | A | 9 |
| Example 4 of Present Invention | 57.2 | Zr | 0.4 | 3.43 | 15 | 800 | 120 | Present | 0.19 | A | 10 |
| Example 5 of Present Invention | 85.8 | Hf | 11.2 | 2.45 | 15 | 800 | 180 | Present | 0.89 | A | 10 |
| Example 6 of Present Invention | 28.6 | Ti | 14.6 | 0.49 | 10 | 850 | 90 | Present | 0.66 | A | > 10 |
| Example 7 of Present Invention | 21.5 | Ti | 4.8 | 1.47 | 10 | 700 | 30 | Present | 0.23 | A | > 10 |
| Example 8 of Present Invention | 28.6 | Zr | 9.4 | 2.45 | 5 | 820 | 30 | Present | 0.46 | A | > 10 |
| Example 9 of Present Invention | 21.5 | Nb | 9.4 | 0.294 | 5 | 820 | 60 | Present | 0.38 | A | > 10 |
| Comparative Example 1 | 21.5 | Ti | 1.2 | 0.294 | 2 | 700 | 10 | Present | 0.02 | A | 2 |
| Comparative Example 2 | 28.6 | Zr | 9.4 | 2.45 | 30 | 820 | 30 | Present | 1.46 | A | 3 |
| Comparative Example 3 | 3.6 | Ti | 4.8 | 0.98 | 15 | 850 | 90 | Present | 0.02 | A | 1 |
| Comparative Example 4 | 107.3 | Ti | 4.8 | 0.98 | 15 | 850 | 180 | Present | 1.53 | A | 3 |
| Comparative Example 5 | 57.2 | Zr | 0.2 | 0.98 | 10 | 800 | 120 | Present | 0.03 | A | 1 |
| Comparative Example 6 | 57.2 | Hf | 21.3 | 0.98 | 10 | 800 | 180 | Present | 1.33 | A | 2 |
| Conventional Example 1 | 58.3 (Ag) | Ti | 9.4 | 0.49 | 10 | 850 | 30 | - | 0.91 | C | 10 |

**[Table 2]**

| | Mg and active metal disposing step | | | Bonding step | | | | Mg solid solution layer | Thickness of active metal nitride layer (µm) | Migration resi stance | Reliability of thermal cycle |
|---|---|---|---|---|---|---|---|---|---|---|---|
| | Amount of Mg (µmol/cm²) | Active metal | | Load (MPa) | Temperature increase rate (°C/min) | Holding temperature (°C) | Holding time (min) | | | | |
| | | Element | µmol/cm² | | | | | | | | |
| Example 11 of Present Invention | 57.2 | Zr | 0.4 | 3.43 | 5 | 700 | 10 | Present | 0.05 | A | 16 |
| Example 12 of Present Invention | 85.8 | Zr | 2.8 | 0.098 | 15 | 850 | 180 | Present | 1.17 | A | 15 |
| Example 13 of Present Invention | 28.6 | Ti | 14.6 | 1.47 | 20 | 820 | 90 | Present | 0.71 | A | 20 |
| Example 14 of Present Invention | 28.6 | Nb | 2.8 | 0.049 | 20 | 800 | 90 | Present | 0.72 | A | 20 |
| Example 15 of Present Invention | 28.6 | Hf | 18.8 | 0.49 | 15 | 850 | 120 | Present | 0.76 | A | 19 |
| Example 16 of Present Invention | 14.3 | Ti | 7.2 | 0.98 | 10 | 750 | 60 | Present | 0.27 | A | > 20 |
| Example 17 of Present Invention | 57.2 | Zr | 14.6 | 0.049 | 10 | 800 | 60 | Present | 0.53 | A | > 20 |
| Example 18 of Present Invention | 57.2 | Nb | 7.2 | 0.98 | 5 | 820 | 150 | Present | 0.61 | A | > 20 |
| Example 19 of Present Invention | 28.6 | Hf | 7.2 | 0.49 | 5 | 700 | 150 | Present | 0.44 | A | > 20 |
| Comparative Example 11 | 57.2 | Zr | 0.4 | 0.294 | 1 | 700 | 10 | Present | 0.03 | A | 8 |
| Comparative Example 12 | 57.2 | Nb | 7.2 | 0.98 | 35 | 820 | 150 | Present | 1.39 | A | 12 |
| Comparative Example 13 | 7.2 | Zr | 14.6 | 1.47 | 10 | 820 | 90 | Present | 0.02 | A | 4 |
| Comparative Example 14 | 114.4 | Hf | 14.6 | 1.47 | 10 | 820 | 90 | Present | 1.42 | A | 12 |
| Comparative Example 15 | 71.5 | Nb | 0.3 | 1.47 | 15 | 850 | 120 | Present | 0.02 | A | 3 |
| Comparative Example 16 | 71.5 | Ti | 24.4 | 1.47 | 15 | 850 | 120 | Present | 1.48 | A | 10 |
| Conventional Example 11 | 77.8 (Ag) | Ti | 14.1 | 0.98 | 10 | 850 | 60 | - | 1.03 | C | 18 |

In Comparative Example 1 in which a temperature increase rate in a temperature range of 450°C or higher and lower than 650°C was set to 2 °C/min and Comparative Example 11 in which a temperature increase rate in a temperature range of 450°C or higher and lower than 650°C was set to 1 °C/min, the thickness of the active metal nitride layer was thinner than the range of the present invention, and the reliability of the thermal cycle was lowered.

In Comparative Example 2 in which a temperature increase rate in a temperature range of 450°C or higher and lower than 650°C was set to 30 °C/min and Comparative Example 12 in which a temperature increase rate in a temperature range of 450°C or higher and lower than 650°C was set to 35 °C/min, the thickness of the active metal nitride layer was thicker than the range of the present invention, and the reliability of the thermal cycle was lowered.

In Comparative Example 3 in which the amount of Mg was set to 3.6 µmol/cm² and Comparative Example 13 in which the amount of Mg was set to 7.2 µmol/cm², the thickness of the active metal nitride layer was thinner than the range of the present invention, and the reliability of the thermal cycle was lowered.

In Comparative Example 4 in which the amount of Mg was set to 107.3 µmol/cm² and Comparative Example 14 in which the amount of Mg was set to 114.4 µmol/cm², the thickness of the active metal nitride layer was thicker than the range of the present invention, and the reliability of the thermal cycle was lowered.

In Comparative Example 5 in which the amount of active metal (Zr) was set to 0.2 µmol/cm² and Comparative Example 15 in which the amount of active metal (Nb) was set to 0.3 µmol/cm², the thickness of the active metal nitride layer was thinner than the range of the present invention, and the reliability of the thermal cycle was lowered.

In Comparative Example 6 in which the amount of active metal (Hf) was set to 21.3 µmol/cm² and Comparative Example 16 in which the amount of active metal (Ti) was set to 24.4 µmol/cm², the thickness of the active metal nitride layer was thicker than the range of the present invention, and the reliability of the thermal cycle was lowered.

In Conventional Example 1 and Conventional Example 11 using the bonding material containing Ag and Ti, the migration resistance was "C".

On the other hand, in Examples 1 to 9 and 11 to 19 of Present Invention in which the thickness of the active metal nitride layer was in the range of the present invention, breaking in the ceramic member was suppressed even when the thermal cycle was loaded, and the reliability of the thermal cycle was excellent. In addition, excellent migration resistance was obtained.

### (Example 2)

As in Example 1, a ceramic substrate (40 mm × 40 mm × 0.635 mm) made of aluminum nitride (AlN) and a ceramic substrate (40 mm × 40 mm × 0.32 mm) made of silicon nitride (Si₃N₄) were prepared.

A copper plate (37 mm × 37 mm × thickness of 0.3 mm) made of oxygen-free copper was bonded to both surfaces of the ceramic substrate under the conditions shown in Tables 3 and 4 to obtain an insulating circuit substrate (copper/ceramic bonded body). A degree of vacuum of a vacuum furnace at the time of bonding was set to 8 × 10⁻³ Pa.

Here, in Examples 21 to 25 of Present Invention, a ceramic substrate made of aluminum nitride (AlN) was used. In addition, in Examples 31 to 35 of Present Invention, a ceramic substrate made of silicon nitride (Si₃N₄) was used.

For the obtained insulating circuit substrate (copper/ceramic bonded body), the thickness of the active metal nitride layer at the bonding interface, the presence or absence of the Mg solid solution layer, and migration resistance were evaluated in the same manner as in Example 1.

In addition, the presence or absence of Cu-containing particles in the active metal nitride layer and ultrasonic bonding evaluation were evaluated as follows.

### (Presence or Absence of Cu-Containing Particles)

An observation specimen was collected from the central portion of the obtained insulating circuit substrate (copper/ceramic bonded body), the bonding interface between the copper plate and the ceramic substrate was observed under the conditions of a magnification of 40,000 to 115,000 and an acceleration voltage of 200 kV by using a scanning transmission electron microscope (Titan ChemiSTEM (with EDS detector) manufactured by FEI Company), mapping was performed using an energy dispersive X-ray analysis method (NSS7 manufactured by Thermo Fisher Scientific K.K.), to obtain an electron diffraction pattern by irradiating a region where the active metal and N overlap each other with an electron beam narrowed to about 1 nm (nano beam diffraction (NBD) method), and the active metal nitride layer was confirmed.

Here, when Cu was detected in a region where the active metal and N overlapped each other, it was determined that the Cu-containing particles were "present". The equivalent circle diameter of the Cu-containing particles was 10 nm to 100 nm.

### (Evaluation of Ultrasonic Bonding)

A copper terminal (in a case of AlN: 10 mm × 5 mm × 1 mm in thickness, and in a case of Si₃N₄: 10 mm × 10 mm × 1 mm in thickness) was ultrasonically bonded to the obtained insulating circuit substrate (copper/ceramic bonded body) using an ultrasonic metal bonding machine (60C-904 manufactured by Ultrasonic Engineering Co., Ltd.) under the condition of a collapse amount of 0.5 mm. Ten copper terminals were bonded at a time.

After bonding, the bonding interface between the copper plate and the ceramic substrate was inspected by using an ultrasonic flaw detector (FSP8V manufactured by Hitachi Power Solutions Co., Ltd.). A case where peeling of the copper plate from the ceramic substrate or ceramic breaking was observed in 3 pieces or more out of 10 pieces was evaluated as "C", a case where peeling of the copper plate from the ceramic substrate or ceramic breaking was observed in 1 piece or more and 2 pieces or less out of 10 pieces was evaluated as "B", and a case where peeling of the copper plate from the ceramic substrate or ceramic breaking was not observed in all 10 pieces was evaluated as "A". The evaluation results are shown in Tables 3 and 4.

**[Table 3]**

| | | Mg and active metal disposing step | | | Bonding step | | | | Mg solid solution layer | Thickness of active metal nitride layer (µm) | Presence or absence of Cu-containing particles | Migration resistance | Evaluation of ultrasonic bonding |
|---|---|---|---|---|---|---|---|---|---|---|---|---|---|
| | | Amount of Mg (µmol/cm²) | Active metal | | Load (MPa) | Temperature increase rate (°C/min) | Holding temperature (°C) | Holding time (min) | | | | | |
| | | | Element | µmοl/cm² | | | | | | | | | |
| Examples of Present Invention | 21 | 21.5 | Ti | 4.8 | 1.47 | 10 | 700 | 10 | Present | 0.11 | Absent | A | B |
| | 22 | 21.5 | Ti | 4.8 | 1.47 | 10 | 700 | 30 | Present | 0.23 | Present | A | A |
| | 23 | 21.5 | Ti | 4.8 | 1.47 | 10 | 700 | 90 | Present | 0.41 | Present | A | A |
| | 24 | 28.6 | Zr | 9.4 | 2.45 | 20 | 820 | 30 | Present | 0.41 | Absent | A | B |
| | 25 | 28.6 | Zr | 9.4 | 2.45 | 5 | 820 | 30 | Present | 0.46 | Present | A | A |

**[Table 4]**

| | | Mg and active metal disposing step | | | Bonding step | | | | Mg solid solution layer | Thickness of active metal nitride layer (µm) | Presence or absence of Cu-containing particles | Migration resistance | Evaluation of ultrasonic bonding |
|---|---|---|---|---|---|---|---|---|---|---|---|---|---|
| | | Amount of Mg (µmol/cm²) | Active metal | | Load (MPa) | Temperature increase rate (°C/min) | Holding temperature (°C) | Holding time (min) | | | | | |
| | | | Element | µmol/cm² | | | | | | | | | |
| Examples of Present Invention | 31 | 14.3 | Ti | 7.2 | 0.98 | 20 | 750 | 60 | Present | 0.19 | Absent | A | B |
| | 32 | 14.3 | Ti | 7.2 | 0.98 | 10 | 750 | 60 | Present | 0.27 | Present | A | A |
| | 33 | 14.3 | Ti | 7.2 | 0.98 | 5 | 750 | 60 | Present | 0.31 | Present | A | A |
| | 34 | 28.6 | Hf | 7.2 | 0.49 | 5 | 700 | 150 | Present | 0.44 | Present | A | A |
| | 35 | 28.6 | Hf | 7.2 | 0.49 | 5 | 850 | 150 | Present | 0.68 | Present | A | A |

In Examples 22, 23, and 25 of Present Invention and Examples 32, 33, 34 of Present Invention, and 35 in which Cu-containing particles were confirmed inside the active nitride layer, the ultrasonic bonding evaluation was "A", and it was confirmed that, compared with Examples 21 and 24 of Present Invention and Example 31 of Present Invention in which Cu-containing particles were not observed, it was possible to suppress peeling of the copper plate from the ceramic substrate during ultrasonic bonding and occurrence of cracks in the ceramic substrate.

As a result, according to the Examples of the present invention, it was confirmed that it is possible to provide a copper/ceramic bonded body, an insulating circuit substrate, a production method of a copper/ceramic bonded body, and a production method of an insulating circuit substrate, which can suppress occurrence of breaking of a ceramic member even when severe thermal cycle is loaded, and are excellent in migration resistance.

### [Industrial Applicability]

It is possible to provide a copper/ceramic bonded body, an insulating circuit substrate, a production method of a copper/ceramic bonded body, and a production method of an insulating circuit substrate, which can suppress occurrence of breaking of a ceramic member even when severe thermal cycle is loaded, and are excellent in migration resistance.

### [Reference Signs List]

10: Insulating circuit substrate (copper/ceramic bonded body)
11: Ceramic substrate (ceramic member)
12: Circuit layer (copper member)
13: Metal layer (copper member)
41: active metal nitride layer

## Claims

1. A copper/ceramic bonded body comprising:
a copper member made of copper or a copper alloy; and
a ceramic member made of nitrogen-containing ceramics, the copper member and the ceramic member being bonded to each other,
wherein a Mg solid solution layer in which Mg is solid-soluted in a Cu matrix is formed at a bonding interface between the copper member and the ceramic member,
an active metal nitride layer containing a nitride of one or more active metals selected from Ti, Zr, Nb, and Hf is formed on a ceramic member side, and
a thickness of the active metal nitride layer is set to be in a range of 0.05 µm or more and 1.2 µm or less.

2. The copper/ceramic bonded body according to Claim 1,
wherein the active metal is Ti.

3. The copper/ceramic bonded body according to Claim 1 or 2,
wherein Cu-containing particles are present inside the active metal nitride layer.

4. An insulating circuit substrate comprising:
a copper plate made of copper or a copper alloy; and
a ceramic substrate made of nitrogen-containing ceramics, the copper plate being bonded to a surface of the ceramic substrate,
wherein a Mg solid solution layer in which Mg is solid-soluted in a Cu matrix is formed at a bonding interface between the copper plate and the ceramic substrate,
an active metal nitride layer containing a nitride of one or more active metals selected from Ti, Zr, Nb, and Hf is formed on a ceramic substrate side, and
a thickness of the active metal nitride layer is set to be in a range of 0.05 µm or more and 1.2 µm or less.

5. The insulating circuit substrate according to Claim 4,
wherein the active metal is Ti.

6. The insulating circuit substrate according to Claim 4 or 5,
wherein Cu-containing particles are present inside the active metal nitride layer.

7. A method of producing the copper/ceramic bonded body according to any one of Claims 1 to 3, the production method comprising:
an active metal and Mg disposing step of disposing one or more active metals selected from Ti, Zr, Nb, and Hf and Mg between the copper member and the ceramic member;
a laminating step of laminating the copper member and the ceramic member with the active metal and Mg interposed therebetween; and
a bonding step of performing a heating treatment on the laminated copper member and ceramic member with the active metal and Mg interposed therebetween in a state of being pressed in a lamination direction under a vacuum atmosphere to bond the copper member and the ceramic member to each other,
wherein, in the active metal and Mg disposing step, an amount of the active metal is set to be in a range of 0.4 µmol/cm² or more and 18.8 µmol/cm² or less, and an amount of Mg is set to be in a range of 14 µmol/cm² or more and 86 µmol/cm² or less, and
in the bonding step, a temperature increase rate in a temperature range of 450°C or higher and lower than 650°C is set to 5 °C/min or higher and 20 °C/min or lower, a holding temperature is set to be in a range of 700°C or higher and 850°C or lower, and a holding time at the holding temperature is set to be in a range of 10 minutes or longer and 180 minutes or shorter.

8. A method of producing the insulating circuit substrate according to any one of Claims 4 to 6, the production method comprising:
an active metal and Mg disposing step of disposing one or more active metals selected from Ti, Zr, Nb, and Hf and Mg between the copper plate and the ceramic substrate;
a laminating step of laminating the copper plate and the ceramic substrate with the active metal and Mg interposed therebetween; and
a bonding step of performing a heating treatment on the laminated copper plate and ceramic substrate with the active metal and Mg interposed therebetween in a state of being pressed in a lamination direction under a vacuum atmosphere to bond the copper plate and the ceramic substrate to each other,
wherein, in the active metal and Mg disposing step, an amount of the active metal is set to be in a range of 0.4 µmol/cm² or more and 18.8 µmol/cm² or less, and an amount of Mg is set to be in a range of 14 µmol/cm² or more and 86 µmol/cm² or less, and
in the bonding step, a temperature increase rate in a temperature range of 450°C or higher and lower than 650°C is set to 5 °C/min or higher and 20 °C/min or lower, a holding temperature is set to be in a range of 700°C or higher and 850°C or lower, and a holding time at the holding temperature is set to be in a range of 10 minutes or longer and 180 minutes or shorter.
